(19) 

**Europäisches Patentamt**
**European Patent Office**
**Office européen des brevets**

(11) **EP 1 164 399 B1**

(12) **EUROPÄISCHE PATENTSCHRIFT**

(45) Veröffentlichungstag und Bekanntmachung des Hinweises auf die Patenterteilung:
**08.08.2007 Patentblatt 2007/32**

(51) Int Cl.:
*G03F 7/20* (2006.01)  *G02B 13/14* (2006.01)
*G02B 1/06* (2006.01)

(21) Anmeldenummer: **01110646.5**

(22) Anmeldetag: **02.05.2001**

(54) **Projektionsobjektiv, insbesondere für die Mikrolithographie**

Projection objective lens, especially for microlithography

Objectif de projection, en particulier pour la microlithographie

(84) Benannte Vertragsstaaten:
**DE FR IT NL**

(30) Priorität: **04.05.2000 DE 10021739**
**24.04.2001 DE 10119861**

(43) Veröffentlichungstag der Anmeldung:
**19.12.2001 Patentblatt 2001/51**

(73) Patentinhaber: **Carl Zeiss SMT AG**
**73446 Oberkochen (DE)**

(72) Erfinder:
• **Singer, Wolfgang, Dr.**
**73431 Aalen (DE)**

• **Schuster, Karl-Heinz**
**89551 Koenigsbronn (DE)**

(74) Vertreter: **Lorenz, Werner**
**Lorenz & Kollegen**
**Patent- und Rechtsanwaltskanzlei**
**Alte Ulmer Strasse 2-4**
**89522 Heidenheim (DE)**

(56) Entgegenhaltungen:
**JP-A- 8 241 861**    **JP-A- 11 297 620**
**US-A- 4 690 528**    **US-A- 4 871 237**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## EP 1 164 399 B1

### Beschreibung

Die Erfindung betrifft ein Projektionsobjektiv, insbesondere für die Mikrolithographie mit einer Linsenanordnung, nach der im Oberbegriff von Anspruch 1 näher definierten Art. Die Erfindung betrifft auch ein Verfahren zur Herstellung mikrostrukturierter Bauteile mit einer Projektionsbelichtungsanlage.

Aus der US 4,871,237 ist es bereits bekannt, in Abhängigkeit vom barometrischen Druck ein Objektiv abzustimmen und zwar über den Brechungsindex eines Füllgases in Linsenzwischenräumen. Durch eine geeignete Kombination von Zwischenräumen können z.B. sphärische Aberration, Koma und andere Fehler korrigiert werden. Nachteilig bei diesem Objektiv ist jedoch, daß mit der Beseitigung eines Fehlers, z.B. einer sphärischen Aberration, andere Fehler initiiert werden.

Aus der US 4,676,614 ist eine Projektionsbelichtungsanlage bekannt, die einen Gasraum umfaßt, der mit Druck beaufschlagbar ist. Durch eine gezielte Druckbeaufschlagung können die durch eine Druckänderung des atmosphärischen Drucks bedingten Bildfehler kompensiert werden.

Aus der US 5,559,584 ist es bekannt, bei einer Projektionsbelichtungsanlage zur Herstellung mikrostrukturierter Bauteile in den Zwischenraum zwischen einem Wafer und/oder einem Reticle und dem Projektionsobjektiv Schutzgas einzubringen.

Durch Umwelteinflüsse, wie z.B. Luftdruckänderung, entsteht bei Lithographieobjektiven unter anderem sphärische Aberration als Bildfehler. Andere Einflußgrößen sind lens-heating und compaction, welche ebenfalls zu sphärischer Aberration führen. Insbesondere bei hoher numerischer Apertur wird der Betrag der sphärischen Aberration sehr groß und bei den geforderten Genauigkeiten nicht mehr tolerierbar.

Bekannt ist es, neben der eingangs erwähnten US 4,871,237, bei DUV-Objektiven durch Wellenlängenänderungen barometrische und wetterbedingte Druckänderungen zu kompensieren. Bei 365 nm, 193 nm-Objektiven funktioniert dieses Verfahren jedoch nicht mehr und zwar aufgrund der chromatischen Korrektion der Objektive, d.h. bei Verwendung verschiedener Materialien führt die unterschiedliche Variation der Brechzahlen mit der Wellenlänge zu nicht tolerierbaren Bildfehlern.

Bekannt ist es auch aus der Praxis, zur Kompensation von Restfehlern, verursacht durch Umwelteinflüsse, z-Manipulatoren einzusetzen, das heißt z.B. in Richtung der optischen Achse aktiv verschiebbare Linsenelemente. Nachteilig bei diesem Verfahren ist jedoch, neben dem hierfür erforderlichen großen Aufwand, daß man damit ebenfalls wieder andere Fehler einführt.

Allen bekannten Verfahren ist deshalb gemeinsam, daß sie mehr oder weniger gut sphärische Aberration kompensieren, jedoch gleichzeitig wieder andere Fehler einführen oder nur unvollständig wirken. Ein erschwerender Faktor kommt hinzu, wenn die verwendeten optischen Materialien, insbesondere Linsen, aus unterschiedlichen Materialien, wie z.B. Kalziumfluorid und Quarzglas bestehen, weil dadurch unterschiedlich variierende Brechzahlen über der Wellenlänge auftreten, falls über die Wellenlänge manipuliert werden soll.

Der vorliegenden Erfindung liegt die Aufgabe zugrunde, ein Projektionsobjektiv zu schaffen, das mit weniger Linsen eine sehr gute Qualität, insbesondere auch bei hoher Apertur, aufweist, wobei gleichzeitig auch Korrekturmöglichkeiten gegeben sein sollen. Insbesondere soll eine Korrektur des konstanten Feldanteiles einer sphärische Aberration ermöglicht werden. Ebenso liegt der Erfindung die Aufgabe zugrunde, ein Verfahren zur Herstellung mikrostrukturierter Bauteile zu schaffen, bei dem sphärische Aberration soweit wie möglich korrigiert werden kann.

Erfindungsgemäß wird diese Aufgabe durch die im kennzeichnenden Teil von Anspruch 1 genannten Merkmale gelöst.

Eine weitere Lösung der Aufgabe ist in Anspruch 8 aufgezeigt.

In Anspruch 20 ist ein Verfahren zur Herstellung mikrostrukturierter Bauteile beschrieben.

Bei von ebenen Flächen begrenzten parallelen Räumen und Elementen entsteht in gut telezentrischen Systemen bei Änderung einer Brechzahl, insbesondere hinter und vor einer Abschlußplatte, nur sphärische Aberration. Diese Tatsache wurde nun bei der erfindungsgemäßen Vorrichtung ausgenutzt. Druckänderungen in einem derartigen Raum ändern die sphärische Aberration. Gleiches gilt auch für die Änderung einer Gaszusammensetzung. Dieser Sachverhalt wird erfindungsgemäß nunmehr für eine aktive Manipulation für sphärische Aberration genutzt.

Legt man dabei den Manipulationsraum zwischen einer letzten Abschlußplatte vor dem zu beleuchtenden Substrat und der der Abschlußplatte benachbart liegenden optischen Linse, welche in diesem Falle auf der der Abschlußplatte zugewandten Seite eben sein muß, so lassen sich durch Änderungen des Druckes in dem Manipulationsraum und/oder der Gaszusammensetzung bzw. dessen aktiven Steuerung die auf diese Weise "künstlich" erzeugte sphärische Aberration eine Aberration des Objektives vermeiden bzw. entsprechend korrigieren bzw. kompensieren.

Gleiches gilt auch, wenn man den Manipulationsraum zwischen der Abschlußplatte und der Bildebene einrichtet.

In vorteilhafter Weise wird man vorab ein Vorhalt bzw. Offset der Brechzahl über eine bestimmte Ausgangsgasmischung einstellen, um Brechzahländerungen in beide Richtungen d.h. Erhöhungen und Erniedrigungen, zu ermöglichen.

Mit anderen Worten: Ändert man die Brechzahl in dem Manipulationsraum, so führt man fast ausschließlich sphärische Aberration (konstanter Feldverlauf) ein. Die Änderung der Brechzahl wird erfindungsgemäß durch die gewählte Zusammensetzung des in den Manipulationsraum einzubringenden Gases bzw. Gasgemisches und/oder des Druckes erreicht. Um durch die Druckzugabe keine neuen Fehler einzubringen, z.B. durch Durchbiegungen der den Manipulationsraum begrenzenden Flächen, müssen die den Manipulationsraum abschließenden Elemente den angegebenen Durchmesser/Dickenverhältnissen entsprechen.

In einer sehr vorteilhaften Weiterbildung der Erfindung kann vorgesehen sein, daß neben dem Manipulationsraum zusätzlich ein weiterer manipulierbaren Gaszwischenraum vorgesehen wird. Den weiteren Gaszwischenraum kann man mit einer leichten Brechkraft versehen, d.h. daß wenigstens eine den Gaszwischenraum in z-Richtung begrenzende Fläche mit einer leichten Wölbung versehen ist. Bringt man in diesen Gaszwischenraum ebenfalls ein Gas bzw. ein Gasgemisch ein, dann kann man durch eine Gasmischungsänderung oder auch über eine Druckänderung die Brechkraft verändern. Auf diese Weise läßt sich eine evtl. entstandene Bildfeldwölbung auf dem zu belichtenden Substrat ändern. Für eine möglichst genaue Abbildung auf dem ebenen Substrat soll nämlich keine Bildfeldwölbung vorhanden sein. Ändert sich etwa durch Linsenerwärmung die Bildfeldwölbung, läßt sich diese nachteilige Bildfeldwölbung erfindungsgemäß nunmehr durch den weiteren manipulierbaren Gaszwischenraum beseitigen. Dies gilt insbesondere dann, wenn dieser möglichst nahe an dem zu belichtenden Substrat liegt. Gleichzeitig wird auf diese Weise vermieden, daß man damit wieder andere Fehler erzeugt.

Durch die erfindungsgemäße Ausbildung eines optischen Elementes nach Anspruch 8, das mehr oder weniger eine wenigstens annähernd planparallele Form besitzt und durch die angegebene Dikke, welche im Vergleich zu bekannten optischen Elementen, wie z.B. einer Abschlußplatte eines Objektives, größer ist, ergibt sich der Vorteil, daß z.B. Bildfehler die durch das dicke Element über das Feld entstehen, durch die Planparallelität des optischen Elementes nur unwesentlich verändert werden. Dieses Element reagiert über das Bildfeld immer gleich, weil das Objektiv in diesem Bereich telezentrisch ist. Da dieses optische Element keine oder zumindest keine nennenswerte Krümmungsradien besitzt, können keine Radien auf irgendeine Weise einen ungünstigen Einfluß ausüben, insbesondere, z.B. wenn das Feld zunimmt oder die Apertur zunimmt. Mit anderen Worten: Das optische Element mit den erfindungsgemäßen Maßangaben und Dimensionen führt zu keinen Veränderungen mehr, was bedeutet, daß bestimmte Aberrationen in dem hoch geöffneten Objektiv im Prinzip besser vorhersehbar sind und auf diese Weise weiter vorne bzw. bereits im Eingangsbereich korrigiert werden können.

Wenn in einer sehr vorteilhaften Ausgestaltung der Erfindung vorgesehen ist, daß das optische Element und ein weiteres optisches Element der sechsten optischen Gruppe einen Gasraum einschließen, wobei für den Krümmungsradius R3 der Fläche des zweiten optischen Elementes, die der ersten Linse zugewandt ist, gilt: R3 > 3000 mm, vorzugsweise > 5000 mm, so erhält man auf diese Weise einen quasi planparallelen Gasraum, welcher in einer sehr vorteilhaften Weise der Erfindung als Manipulationsraum verwendet werden kann.

Eine weitere, sehr vorteilhafte und nicht naheliegende Weiterbildung der Erfindung in der Verwendung eines optischen Elementes in der sechsten Linsengruppe mit den angegebenen Krümmungsradien und Durchmesser/Dickeverhältnissen besteht darin, daß man in der ersten Linsengruppe eine Linse mit einer asphärischen Fläche vorsieht.

Mit der erfindungsgemäßen asphärischen Fläche lassen sich bereits im Eingangsbereich des Objektives Korrekturen erreichen, wie z.B. die Beseitigung von Schalenfehler und Bildfeldwölbung. Dies gilt insbesondere bei sehr hoch geöffneten Objektiven und insbesondere dann, wenn man die Asphäre möglichst nahe am Eingang des Objektives anbringt, zumindest vor dem ersten Bauch, am besten bereits an der ersten gekrümmten Fläche.

Erfindungsgemäß ist es damit möglich, Aperturen von mindestens 0,75, vorzugsweise 0,85 zu erreichen, wobei man trotzdem noch ein sehr dickes optisches Element ausgangsseitig, z.B. eine dicke Abschlußplatte, anbringen kann. Da ein optisches Element gemäß Anspruch 1 keine Veränderungen mehr einführt, ist man z.B. in der Lage, die Aberration vorherzusagen, d.h. wie sie sich im Objektiv entwickelt. Mit der erfindungsgemäßen Asphäre läßt sich die Aberration dementsprechend beeinflussen bzw. korrigieren. Dies kann dabei in einer vorteilhaften Weise in einem Bereich erfolgen, in dem die Apertur noch relativ klein ist.

Wenn die Asphäre vor dem ersten Lichtbauch angeordnet ist, ist eine Trennung des Lichtbüschels noch besser durchzuführen.

Die sechste optische Gruppe kann erfindungsgemäß nur aus Planparallelplatten bestehen. Selbstverständlich ist es auch möglich, ein oder zwei Linsen in der sechsten optischen Gruppe vorzusehen, wobei dann zumindest eine Linse eine wenigstens annähernd ebene Fläche aufweisen sollte, die zu einer weiteren planparallelen Fläche, z.B. einer Abschlußplatte, benachbart liegt, damit dazwischen dann der erfindungsgemäße Manipulationsraum gebildet werden kann.

Von Vorteil ist auch, wenn Linsen in der sechsten Linsengruppe und gegebenenfalls auch in der fünften Linsengruppe, d.h. die Linsen, die bei der Mikrolithographie einem Wafer am nächsten liegen, nur positive Brechkraft besitzen. Vorzugsweise wird man an dieser Stelle wenigstens zwei oder drei entsprechende Linsen anordnen.

Vorteilhafte Weiterbildungen der Erfindung ergeben sich aus den übrigen Unteransprüchen und aus den nachfolgend anhand der Zeichnung prinzipmäßig beschriebenen Ausführungsbeispielen.

In den dargestellten Ausführungsbeispielen sind zwar nur rein refraktive Objektive gezeigt, dennoch ist diese Erfindung nicht beschränkt auf refraktive Systeme, sondern auch auf katadioptrischen Systemen zu lesen.

Es zeigt:

Figur 1 eine schematische Darstellung einer erfindungsgemäßen Projektionsbelichtungsanlage mit einem Projektionsobjektiv,

Figur 2 einen Schnitt durch den unteren Teil des Projektionsobjektives mit einer Abschlußplatte und einer daran angrenzenden Linse mit einem Manipulationsraum dazwischen in vergrößerter Darstellung,

Figur 3 einen Manipulationsraum, der durch eine zweigeteilte Abschlußplatte gebildet ist, in vergrößerter Darstellung,

Figur 4 ein Ausführungsbeispiel mit einem Manipulationsraum und einem weiteren Gaszwischenraum in vergrößerter Darstellung,

Figur 5 einen Linsenschnitt durch eine erste Linsenanordnung, und

Figur 6 einen Linsenschnitt durch eine zweite Linsenanordnung.

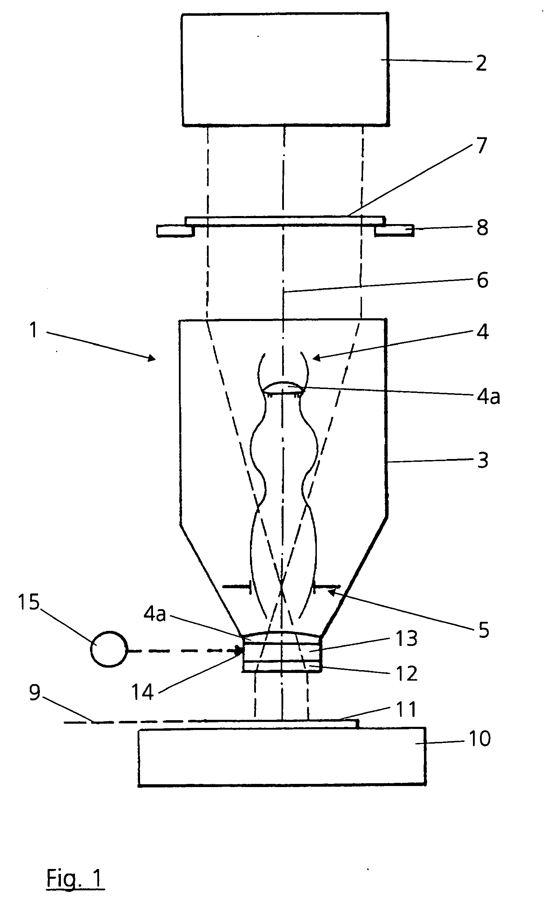

Der prinzipielle Aufbau einer Projektionsbelichtungsanlage 1 ist nachfolgend anhand der Figur 1 beschrieben. Die Projektionsbelichtungsanlage 1 weist eine Beleuchtungseinrichtung 2 und ein Projektionsobjektiv 3 auf. Das Projektionsobjektiv 3 umfaßt eine Linsenanordnung 4 mit einer Vielzahl von in der Figur 1 nicht näher dargestellten Linsen 4a und einer Aperturblende 5. Die Linsen 4a sind entlang einer optischen Achse 6 angeordnet. Zwischen der Beleuchtungseinrichtung 2 und dem Projektionsobjektiv 3 ist eine Maske bzw. Reticle 7 angeordnet, die mittels eines Maskenhalters 8 im Strahlengang gehalten wird. Die Maske 7 wird mittels des Projektionsobjektives 3 in einem deutlich verkleinerten Faktor auf einer Bildebene 9 abgebildet. Solche in der Mikrolithographie verwendete Masken 7 weisen eine Mikrometer- bzw. Nanometerstruktur auf, die mittels des Projektionsobjektives 3 bis zu einem Faktor von 10, insbesondere um den Faktor 4 verkleinert auf der Bildebene 13 abgebildet wird. Die noch auflösbaren minimalen Strukturen hängen von der Wellenlän-Wellenlänge $\lambda$ des für die Beleuchtung verwendeten Lichtes sowie von der Apertur der Aperturblende 5 ab, wobei die maximal erreichbare Auflösung der Projektionsbelichtungsanlage mit Abnehmen der Wellenlänge der Beleuchtungseinrichtung 2 und mit zunehmender Apertur des Projektionsobjektives 3 steigt.

In der Bildebene 9 ist ein durch einen Substrathalter 10 positioniertes Substrat bzw. ein Wafer 11 gehalten.

Den Abschluß des Projektionsobjektives 3 in Richtung des Wafers 11 bildet eine ebene Abschlußplatte 12. Auf Abstand zu der Abschlußplatte 12 befindet sich eine letzte Linse 4a der Linsenanordnung 4. Zwischen der Abschlußplatte 12 und der letzten Linse 4a wird auf diese Weise ein Manipulationsraum 13 geschaffen, der gegen die umgebenden Teile abgedichtet ist. Wie ersichtlich, ist die der Abschlußplatte 12 zugewandte Seite der letzten Linse 4a ebenfalls plan, womit eine Planparallelität für den Manipulationsraum 13 geschaffen wird. Selbstverständlich ist es nicht unbedingt erforderlich, daß die der Abschlußplatte 12 zugewandte Seite der letzten Linse 4a absolut planparallel ist. Bei entsprechend großen Linsenradien, z.B. mit Radien R > 3000 mm, vorzugsweise > 5000 mm, wird ebenfalls quasi eine Planparallelität erreicht, durch die es möglich ist, die Erzeugung der sphärischen Aberration in dem Manipulationsraum 13 entsprechend zu beeinflussen.

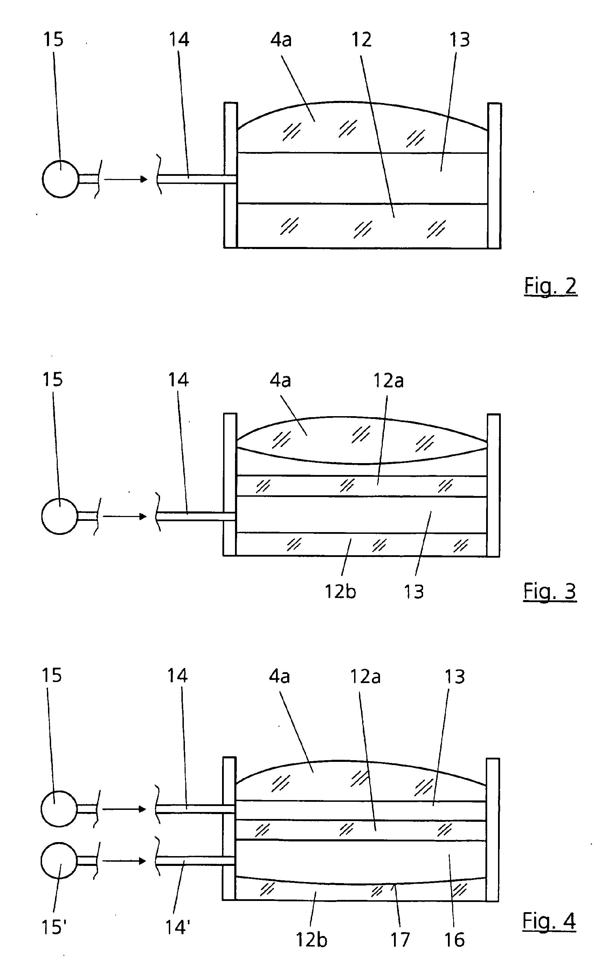

Der Manipulationsraum 13 ist mit einem Druckanschluß 14 versehen, über den er mit einer nicht näher dargestellten Gasquelle 15 verbunden ist (siehe auch vergrößerte Darstellung in Figur 2).

Durch Änderung der Gaszusammensetzung, welche in den Manipulationsraum 13 von der Gasquelle 15 aus eingebracht wird und/oder eine Druckänderung, werden Brechzahländerungen in das Projektionsobjektiv 3 eingebracht und zwar kurz vor dem Austritt, womit keine weiteren Abbildungsfehler mehr eingebracht werden können. Durch die Änderung der Brechzahl wird eine sphärische Aberration geschaffen, die man dazu verwendet, eine in dem Projektionsobjektiv 3 aufgetretene sphärische Aberration zu kompensieren oder auch in eine gewünschte Richtung zu manipulieren.

Anstelle eines Manipulationsraumes zwischen der Abschlußplatte 12 und der daran angrenzenden letzten Linse 4a kann ein planparalleler Manipulationsraum auch durch eine Zweiteilung der Abschlußplatte 12 erreicht werden. In diesem Falle sind die beiden Abschlußplattenteile 12a und 12b auf Abstand voneinander angeordnet und bilden zwischen ihren planparallelen Flächen den Manipulationsraum 13. Selbstverständlich ist es in diesem Falle erforderlich, die beiden Abschlußplattenteile mit einer entsprechenden Dicke auszubilden, damit es zu keinen Verbiegungen kommt (siehe Figur 3). Aus diesem Grunde sollte ein Verhältnis von Dicke d1 zu Durchmesser DU1 von 1 : 5 vorzugsweise 1 : 3 eingehalten sein.

Die Figur 4 zeigt eine Ausführungsform mit einem zusätzlichen Gaszwischenraum 16 neben dem Manipulationsraum 13. Um einen möglichst hohen Wirkungsgrad für den Manipulator zu erzielen, wird der Gaszwischenraum 16 möglichst nahe an dem Wafer 11 angeordnet, so daß in diesem Falle der Manipulationsraum 13 entsprechend weiter zurückliegt. Der Gaszwischenraum 16 wird dabei ebenfalls durch eine Zweiteiligkeit der Abschlußplatte 12 in die beiden Plattenteile 12a und 12b geschaffen. Der Zwischenraum 16 ist ebenfalls über einen eigenen Druckanschluß 14' mit einer Gasquelle 15' verbunden. Im Unterschied zu dem Manipulationsraum 13 ist jedoch wenigstens eine der beiden quer zur z-Richtung liegenden Fläche mit einer leichten Krümmung 17 versehen.

Wenn man weiß, daß das Projektionsobjektiv an einem bestimmten Ort, d.h. bei einer bestimmten barometrischen Höhe eingesetzt wird, so empfiehlt sich folgendes Vorgehen:

Einsatzort z.B. auf 1700 Meter Höhe mit entsprechend reduziertem oder erhöhtem Luftdruck gegenüber dem Objektivhersteller. Beim Abstimmen des Objektives beim Hersteller, der sich z.B. auf Meereshöhe oder einer anderen niedrigeren Höhe als der des Einsatzortes befindet, wird der Manipulationsraum mit einer gezielt eingestellten Gasmischung versehen, deren Brechzahlen um die um die durch Druckdifferenz verursachte Brechzahl höher ist, als der am Einsatzort. Auf diese Weise kann später am Einsatzort der Manipulationsraum einfach mit einem üblichen Füllgas, z.B. synthetische Luft, Sauerstoff, Stickstoff oder Helium, mit dem durchschnittlichen Druck am Aufstellort gefüllt werden, was damit ein exakt abgestimmtes Objektiv ergibt. Natürliche wetterbedingte Luftdruckänderungen gleicht man nun durch kleine Druckänderungen im Manipulationsraum aus. Der Vorteil dieses Verfahrens besteht darin, daß der Kunde nur übliches Füllgas in den Manipulationsraum einfüllen muß und nur geringe Druckdifferenzen eingestellt werden müssen.

Möchte man sich nicht festlegen, wo der spätere Einsatzort liegt, so stimmt man mit dem üblichen Füllgas ab. Allerdings muß dann später eine höher brechende Gasmischung am Einsatzort benützt werden, wenn die barometrische Höhe steigt. Luftdruckänderungen durch das Wetter werden dabei ebenfalls jedoch durch kleine Änderungen des Gasdruckes im Manipulationsraum ausgeglichen.

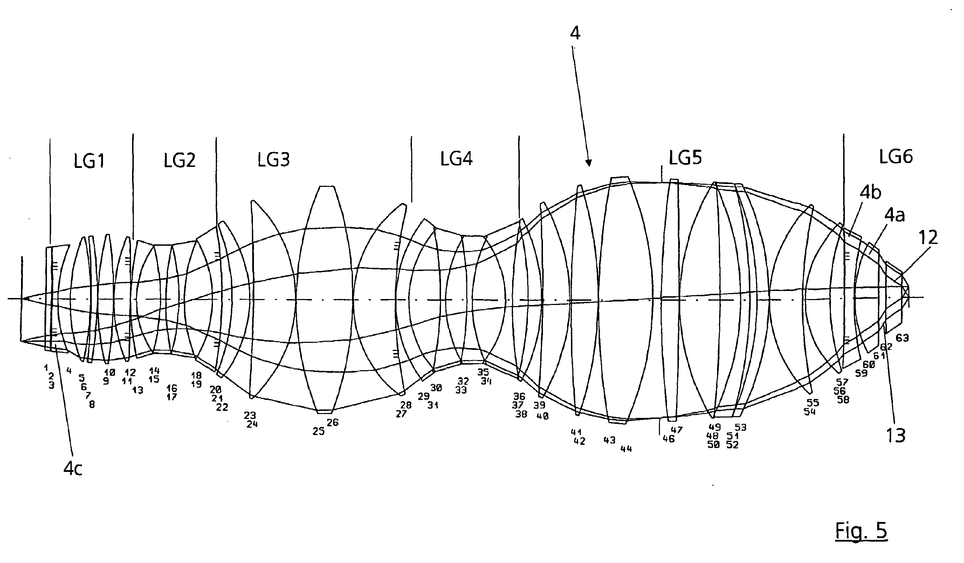

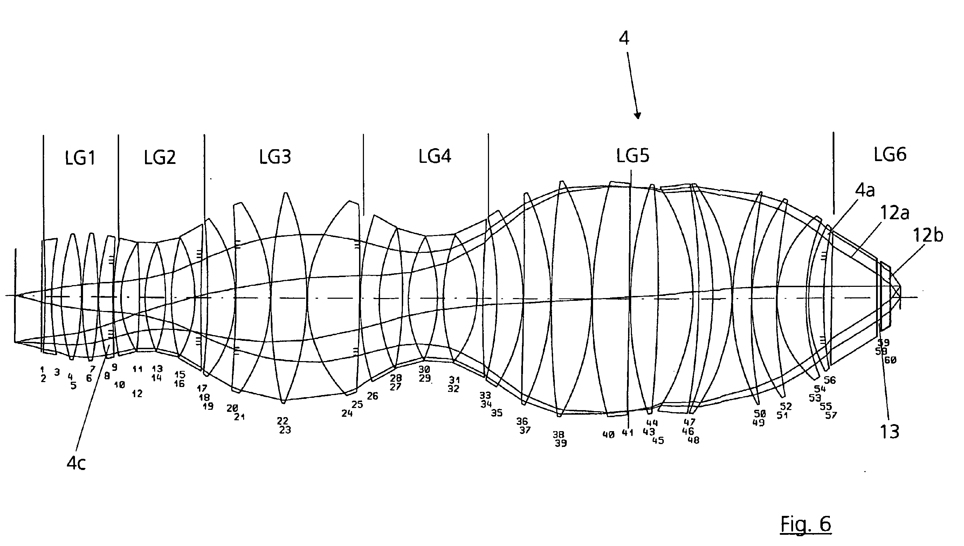

In den Figuren 5 und 6 sind beispielsweise Linsenschnitte durch Linsenanordnungen dargestellt.

Die Ausführungsbeispiele beziehen sich auf ein Projektionsobjektiv 3 mit einer Linsenanordnung 4, die in sechs optischen Gruppen (LG1 bis LG 6) unterteilt ist. Die erste, dritte und fünfte Linsengruppe weisen positive Brechkraft auf und die zweite und vierte Linsengruppe weisen jeweils negative Brechkraft auf. Im folgenden wird die Unterteilung des Linsensystems in Linsengruppen näher ausgeführt, wobei die Ausbreitungsrichtung der Strahlen zugrunde gelegt worden ist.

Die erste Linsengruppe LG 1 ist positiv und endet mit einer Linse positiver Brechkraft. Durch die erste Linsengruppe wird ein Bauch gebildet, wobei es unerheblich ist, wenn in dem Bauch auch Negativlinsen angeordnet sind.

Die zweite Linsengruppe LG 2 ist in ihrer Gesamtbrechkraft negativ. Diese zweite Linsengruppe LG 2 weist als erste Linse eine bildseitig mit einer konkaven Linsenoberfläche ausgebildete Linse auf. Diese zweite Linsengruppe LG 2 beschreibt im wesentlichen eine Taille. Auch hier ist es nicht maßgeblich, wenn einzelne positive Linsen in der zweiten Linsengruppe LG 2 enthalten sind, solange die Taille erhalten bleibt.

Die dritte Linsengruppe LG 3 beginnt mit einer Linse positiver Brechkraft, die bildseitig eine konvexe Linsenoberfläche aufweist und ein Meniskus sein kann. Ist als erste Linse eine dikke Meniskenlinse vorgesehen, so kann innerhalb der Linse die Trennung der Linsengruppen gedacht sein.

Die vierte Linsengruppe LG 4 ist von negativer Brechkraft. Diese vierte Linsengruppe beginnt mit einer Linse negativer Brechkraft, auf die mehrere Linsen mit negativer Brechkraft folgen. Durch diese Linsengruppe wird eine Taille gebildet. Es ist unerheblich, ob innerhalb dieser Linsengruppe auch Linsen positiver Brechkraft angeordnet sind, solange diese den Strahlenverlauf nur auf einer kurzen Distanz beeinflußt und somit die Taillenform der vierten Linsengruppe erhalten bleibt.

Die fünfte Linsengruppe LG 5 ist in ihrer Gesamtheit von positiver Brechkraft. Die erste Linse dieser fünften Linsengruppe LG 5 weist bildseitig eine konvexe Linsenfläche auf. Durch die fünfte Linsengruppe LG 5 wird ein Bauch gebildet.

Nach der Linse mit dem maximalen Durchmesser (der Bauch) folgen noch mindestens zwei positive Linsen in der fünften Linsengruppe LG 5, wobei auch noch negative Linsen zugelassen sind. Die letzte Linse der fünften Linsengruppe LG 5 weist bildseitig eine konkave Linsenfläche auf.

Die sechste optische Gruppe LG 6 umfaßt die optischen Elemente nach der fünften Linsengruppe bis zur Bildebene.

Solche Projektionsobjektive werden insbesondere in der Mikrolithographie eingesetzt. Sie sind z.B. aus den DE 199 42 281 A, DE 198 55 108 A, DE 198 55 157 A und DE 198 55 158 A der Anmelderin und dem dort zitierten Stand der Technik bekannt. Diese Schriften sollen auch Inhalt dieser Anmeldung sein.

Herkömmlich weisen diese Objektive in der ersten und sechsten Gruppe Lufträume auf, die in der Regel bis auf den Luftraum zwischen Objektebene und erster optischer Fläche und den Luftraum zwischen letzter optischer Fläche und Bildebene zumindestens auf einer Seite durch eine gekrümmte Fläche begrenzt werden.

Die Figuren 5 und 6 sind sich in ihrem grundsätzlichen Aufbau ähnlich. Bei der Figur 5 ist der Manipulationsraum 13 zwischen der Abschlußplatte 12 und der Linse 4a gebildet entsprechend der Prinzipdarstellung in der Figur 4.

In der Figur 6 ist die Abschlußplatte zweiteilig ausgebildet, nämlich mit den Teilen 12a und 12b und der Manipulationsraum 13 befindet sich dazwischen, wie es auch aus der Prinzipdarstellung der Figur 3 ersichtlich ist. Eine Linse ist bei diesem Ausführungsbeispiel in der sechsten Gruppe nicht mehr vorgesehen.

In der ersten Linsengruppe LG 1 kann eine Linse 4c mit einer asphärischen Fläche vorgesehen sein, wobei die asphärische Fläche in Lichtrichtung vor dem ersten Bauch angeordnet sein kann. Vorzugsweise weist das Projektionsobjektiv 3 bildseitig eine numerische Apertur von mindestens 0,75, vorzugsweise 0,85, auf.

Als Lichtquelle kann man für die Mikrolithographie einen Laser verwenden, der eine Strahlung von kürzerer Wellenlänge als 250 nm abgibt.

Bei der Herstellung mikrostrukturierter Bauteile, bei der das mit einer lichtempfindlichen Schicht versehene Substrat 11 mittels der Maske 7 und der Projektionsbelichtungsanlage 1 durch ultraviolettes Laserlicht belichtet wird, wird gegebenenfalls nach dem Entwickeln der lichtempfindlichen Schicht entsprechend ein auf der Maske 11 enthaltenes Muster strukturiert.

Figur 5 zeigt die Realisierbarkeit eines Lithographieobjektives bezüglich eines manipulierbaren planparallelen Luftraumes im ausgehenden Teil zum Wafer hin. Bisher war es nicht bekannt, einen derart dicken planparallelen Luftraum und eine dicke planparallele Platte in einem derart hoch geöffneten Objektiv bereit zu stellen.

Aberrationen die bisher im absteigenden Bereich des dritten Bauches korrigiert wurden, sollten nun vorwiegend im Bereich erster Bauch, erste Taille, zweiter Bauch korrigiert werden. Es wurde gefunden, daß dies sogar deutlich korrektive Vorteile aufweist, wenn bei höchster Apertur die Optik mit einer dicken Planparallelplatte abschließt. Deshalb wurde dieses Verfahren weiter getrieben, in dem die dicke Platte deutlich an Dicke gewinnt. Das Verhältnis Dicke zu Durchmesser sollte dabei mindestens 1 : 5 betragen. (Beide Platten wirken optisch wie eine einzige dicke Platte).

Figur 6 zeigt eine Ausführung mit einer besonders dicken Planparallelplatte. Sie stellt die Lösung für gleich drei weitere Probleme dar.

Bei der Korrektion von hochgeöffneten Lithographieobjektiven bekommt man sehr hohe sinus i Belastungen im Bereich vor dem Wafer. Die Krümmungen, welche nun einzelne Linsen annehmen können, als Sphäre, verursachen nun Aberrationen mit deutlich unterschiedlicher Wirkung zwischen Bildfeldrand und Bildfeldmitte (auch über der Apertur). Vielfach sind dies Wirkungen, die man im Objektiv sucht und besonders bereitstellt. Hier, bei großen Feldern und höchsten Aperturen, können sie aber unbeherrschbar werden oder doch wenigstens die Korrektion stören. Die Lösung stellt nun tatsächlich eine sehr dicke planparallele Platte dar, die den gewünschten Beitrag an sphärischer Überkorrektion liefert, bezüglich des Bildfeldes aber nun völlig isoplanatisch wirkt. Damit lassen sich nun Apertur und Bildfeld sehr groß machen.

Neben dem korrektiven Vorteil kann man die Zahl der Linsen, durch das Zusammenfassen zu einer dicken Planparallelplatte verringern. Damit nimmt die Anzahl der Linsenoberflächen mit sehr hoher Winkelbelastung, wie sie vor dem Wafer üblich ist, ab. Die Vorteile sind geringere Kosten und weniger Reflexionsverluste und damit höhere Transmission. Dies ist insbesondere für Wellenlängen von 157 nm und 193 nm bedeutsam. Ein weiterer Aspekt ist, daß die dicke Platte die Zahl der Fassungsteile wesentlich in einem Bereich vereinfachen kann, in dem bekanntermaßen wenig Platz vorhanden ist. Vor dem Wafer sitzen die unterschiedlichsten Bilderkennungssensoren, die sich dicht an die eigentliche Lithographieoptik anschmiegen. Die dicke Planparallelplatte schafft auch hier die Möglichkeit, innerhalb eines bestimmten konstruktiven Raumes mehr Apertur und/oder mehr Feld unterzubringen. Dies ist auch unter dem Aspekt zu sehen, daß man etwa die gleiche Sensorik dann eine weitere Generation länger benutzen kann.

Eine dicke Platte oder dicke Platten vor dem Wafer sind also die erfinderische Lösung für

- Druckmanipulator vor Wafer im Objektiv
- Verbesserte Korrektionsmöglichkeit bei höchster Apertur und großem Feld
- Mehr Apertur und Feld bei gegebenem konstruktivem Platz
- Weniger hochbelastete Flächen, mehr Transmission

Beim Ausführungsbeispiel nach Figur 5 übernimmt eine Asphäre auf der ersten gekrümmten Fläche, Aufgaben die viele Linsen dicht vor dem Wafer teilweise mit übernommen haben. Der Vorteil hier ist nun aber die äußerst geringe Winkelbelastung auf der ersten gekrümmten Fläche. Zugleich läßt sich durch die gute Büscheltrennung ein ganz spezifischer Effekt bezüglich der Wirkung zwischen Bildmitte, Bildfeldzone und Bildfeldrand einstellen.

Grundsätzlich ist es auch möglich einen planparallelen Manipulationsraum auch zwischen einer letzten Abschlußplatte eines Projektionsobjektives und eines Wafers in der Mikrolithographie vorzusehen, in welchem durch Druckänderungen und/oder Gaszusammensetzungsänderungen die Brechzahl veränderbar ist. Für diesen Zweck ist der Zwischenraum zwischen der Abschlußplatte und dem Wafer entsprechend mit Spülgas entsprechender Zusammensetzung und einem entsprechenden Druck zu bespülen. Hierzu ist es im allgemeinen auch erforderlich, das gesamte Projektionsobjektiv "einzukapseln".

Nachfolgend ist beispielsweise jeweils die Designanordnung für die in den Figuren 5 und 6 dargestellten Linsenanordnungen angegeben. Selbstverständlich sind die anhand dieser Ausführungsbeispiele konkretisierten Merkmale und deren Kombinationen miteinander kombinierbar.

Beispiel nach der Figur 5:

Arbeitswellenlänge 1 = 193,3nm
Bildfeld-Durchmesser = 24,6mm
Bildseitige numerische Apertur NA = 0,85
Abbildungsmaßstab β = -0,25
Brechzahl n(SIO2) = 1,5603
Brechzahl n(CAF2) = 1,5014

| Fläche | Radius | Asphäre | Dicke | Material | Durchm. |
|---|---|---|---|---|---|
| OB | | | 32,000 | LUFT | |
| 1 | ∞ | | 6,329 | SIO2 | 110,8 |
| 2 | ∞ | | 1,383 | HE | 112,5 |
| 3 | 1393,131 | A | 6,329 | SIO2 | 112,8 |
| 4 | 153,737 | | 14,539 | HE | 118,0 |
| 5 | 191,890 | | 23,775 | SIO2 | 135,0 |
| 6 | -359,189 | | 0,678 | HE | 136,5 |
| 7 | -827,276 | | 7,196 | SIO2 | 137,7 |
| 8 | -475,714 | | 0,678 | HE | 138,8 |
| 9 | 296,346 | | 18,036 | SIO2 | 141,7 |
| 10 | -561,014 | | 0,678 | HE | 141,4 |
| 11 | 183,662 | | 19,090 | SIO2 | 137,2 |
| 12 | -16545,560 | A | 0,694 | HE | 135,1 |
| 13 | 326,464 | | 6,329 | SIO2 | 129,2 |
| 14 | 106,348 | | 27,957 | HE | 118,2 |
| 15 | -235,452 | | 6,329 | SIO2 | 117,5 |
| 16 | 304,109 | | 15,255 | HE | 118,0 |
| 17 | -232,751 | | 6,329 | SIO2 | 118,5 |
| 18 | 174,842 | | 33,179 | HE | 127,9 |
| 19 | -135,497 | | 10,857 | SIO2 | 132,8 |
| 20 | -567,373 | A | 11,495 | HE | 160,3 |
| 21 | -235,399 | | 21,176 | SIO2 | 165,8 |
| 22 | -145,234 | | 4,213 | HE | 175,6 |
| 23 | -1890,770 | | 49,919 | CAF2 | 219,4 |
| 24 | -156,092 | | 0,678 | HE | 224,3 |
| 25 | 340,445 | | 66,046 | SIO2 | 255,5 |
| 26 | -383,246 | | 0,680 | HE | 254,8 |
| 27 | 137,326 | | 49,212 | CAF2 | 218,0 |
| 28 | 457,970 | A | 0,678 | HE | 209,9 |

(fortgesetzt)

| Fläche | Radius | Asphäre | Dicke | Material | Durchm. |
|---|---|---|---|---|---|
| 29 | 147,683 | | 15,743 | SIO2 | 181,5 |
| 30 | 120,693 | | 37,797 | HE | 159,6 |
| 31 | -420,368 | | 6,329 | SIO2 | 159,6 |
| 32 | 139,505 | | 25,622 | HE | 140,7 |
| 33 | -378,597 | | 6,329 | SIO2 | 140,7 |
| 34 | 167,539 | | 39,624 | HE | 139,8 |
| 35 | -112,503 | | 8,239 | SIO2 | 139,8 |
| 36 | 504,607 | | 18,193 | HE | 174,3 |
| 37 | -369,374 | | 15,678 | SIO2 | 174,6 |
| 38 | -205,396 | | 1,373 | HE | 181,7 |
| 39 | -1692,687 | | 31,888 | CAF2 | 214,3 |
| 40 | -220,732 | | 1,536 | HE | 220,3 |
| 41 | 1213,241 | | 32,223 | CAF2 | 256,7 |
| 42 | -430,691 | | 0,692 | HE | 259,4 |
| 43 | 735,809 | | 63,006 | CAF2 | 274,9 |
| 44 | -355,045 | | 9,223 | HE | 278,5 |
| 45 | ∞ | | 0,633 | HE | 271,7 |
| AS | ∞ | | 0,000 | HE | 271,7 |
| 46 | 1056,085 | | 20,400 | CAF2 | 272,1 |
| 47 | -5047,421 | | 0,792 | HE | 271,5 |
| 48 | 260,901 | | 46,828 | CAF2 | 266,8 |
| 49 | -1697,534 | | 23,712 | HE | 264,5 |
| 50 | -317,482 | | 10,850 | SIO2 | 264,5 |
| 51 | -488,982 | | 8,402 | HE | 262,0 |
| 52 | -339,784 | | 13,562 | SIO2 | 262,0 |
| 53 | -295,518 | | 0,718 | HE | 261,9 |
| 54 | 152,565 | | 37,779 | CAF2 | 213,7 |
| 55 | 505,038 | | 3,020 | HE | 208,6 |
| 56 | 116, 772 | | 28,279 | SIO2 | 168,9 |
| 57 | 258,363 | | 16,383 | HE | 160,8 |
| 58 | -5272,757 | A | 10,966 | SIO2 | 154,6 |
| 59 | 323, 933 | | 0,897 | HE | 133,4 |
| 60 | 142,873 | | 27,124 | CAF2 | 121,2 |
| 61 | ∞ | | 8,137 | LUFT | 102,4 |
| 62 | ∞ | | 18,083 | CAF2 | 76,0 |
| 63 | ∞ | | 12,000 | LUFT | 51,1 |
| Im | | | | | |

Asphärenformel:

$$z = \frac{\frac{1}{R}h^2}{1 + \sqrt{1 - (1 - EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

ASPHÄRE AN FLÄCHE 3

| | |
|---|---|
| RADIUS | = -1393.13098 |
| EX | = .0000000000 |
| C 1 | = .4063752600E-07 |
| C 2 | = .2071817000E-11 |
| C 3 | =-.6785322600E-16 |
| C 4 | = .1029460700E-18 |
| C 5 | =-.2998039200E-22 |
| C 6 | = .3527081700E-26 |

ASPHÄRE AN FLÄCHE 12

| | |
|---|---|
| RADIUS | =-16545.56046 |
| EX | = -43143.0300000000 |
| C 1 | =-.4810999900E-07 |
| C 2 | = .4047924800E-11 |
| C 3 | =-.8963528600E-16 |
| C 4 | = .8505763100E-20 |
| C 5 | =-.2882210400E-23 |
| C 6 | = .5453287000E-27 |

ASPHÄRE AN FLÄCHE 20

| | |
|---|---|
| RADIUS | =-567.37264 |
| EX | = .0000000000 |
| C 1 | =-.3925583500E-08 |
| C 2 | =-.1562788800E-11 |
| C 3 | =-.1025893700E-16 |
| C 4 | =-.2599978800E-20 |
| C 5 | = .8906747700E-25 |
| C 6 | =-.3796689800E-28 |

ASPHÄRE AN FLÄCHE 28

```
RADIUS   = 457.96974
EX       = .0000000000
C 1      = .6773315100E-08
C 2      =-.3998553500E-12
C 3      =-.1364056800E-16
C 4      =-.1474625900E-21
C 5      =-.2509622300E-25
C 6      = .1507291900E-29
```

ASPHÄRE AN FLÄCHE 58

```
RADIUS   = -5272.75688
EX       = .0000000000
C 1      =-.1963426400E-07
C 2      = .2768505300E-12
C 3      = .1262120200E-15
C 4      =-.1811119000E-19
C 5      = .1171493900E-23
C 6      =-.3104888900E-28
```

Beispiel nach Figur 6:

Arbeitswellenlänge 1 = 248,4nm
Bildfeld-Durchmesser = 27,2mm
Bildseitige numerische Apertur NA = 0,8
Abbildungsmaßstab $\beta$ = -0,25
n (SIO2) = 1,5084

| Fläche | Radius | Asphäre | Dicke | Material | Durchm. |
|---|---|---|---|---|---|
| OB | ∞ | | 32,000 | LUFT | |
| 1 | ∞ | | 4,253 | LUFT | 121,9 |
| 2 | -1143,702 | | 7,789 | SIO2 | 122,9 |
| 3 | 366,821 | | 11,482 | LUFT | 127,5 |
| 4 | 249,157 | | 23,794 | SIO2 | 138,2 |
| 5 | -289,424 | | 0,750 | LUFT | 139,4 |
| 6 | 329,633 | | 18,667 | SIO2 | 140,7 |
| 7 | -444,218 | | 0,750 | LUFT | 140,2 |
| 8 | 268,864 | | 16,633 | SIO2 | 135,5 |
| 9 | 1167, 441 | A | 0,750 | LUFT | 131,9 |
| 10 | 360,081 | | 8,628 | SIO2 | 129,2 |

(fortgesetzt)

| Fläche | Radius | Asphäre | Dicke | Material | Durchm. |
|---|---|---|---|---|---|
| 11 | 118,445 | | 21,270 | LUFT | 120,1 |
| 12 | -775,270 | | 7,000 | SIO2 | 119,7 |
| 13 | 156,713 | | 23,965 | LUFT | 118,8 |
| 14 | -190,304 | | 7,000 | SIO2 | 119,8 |
| 15 | 266,520 | | 27,800 | LUFT | 131,4 |
| 16 | -141,408 | | 7,149 | SIO2 | 134,4 |
| 17 | 2327,162 | A | 7,878 | LUFT | 162,8 |
| 18 | -999,626 | | 32,538 | SIO2 | 169,4 |
| 19 | -148,399 | | 0,750 | LUFT | 177,5 |
| 20 | -1179,797 | A | 40,792 | SIO2 | 207,1 |
| 21 | -190,467 | | 0,750 | LUFT | 215,0 |
| 22 | 506,448 | | 42,194 | SIO2 | 236,0 |
| 23 | -318,978 | | 0,750 | LUFT | 236, 6 |
| 24 | 156,565 | | 61,867 | SIO2 | 220,3 |
| 25 | -1909,591 | A | 0,750 | LUFT | 209,4 |
| 26 | 305,588 | | 22,962 | SIO2 | 186,3 |
| 27 | 178,412 | | 27,808 | LUFT | 157,7 |
| 28 | -441,206 | | 7,000 | SIO2 | 154,8 |
| 29 | 141,453 | | 34,534 | LUFT | 138,2 |
| 30 | -176,778 | | 7,000 | SIO2 | 137,5 |
| 31 | 204,086 | | 40,524 | LUFT | 141,8 |
| 32 | -119, 660 | | 7,000 | SIO2 | 143,5 |
| 33 | 1254,417 | | 16,848 | LUFT | 176,1 |
| 34 | -386,520 | | 31,318 | SIO2 | 181,6 |
| 35 | -187,128 | | 0,750 | LUFT | 198,8 |
| 36 | -7551,297 | | 32,372 | SIO2 | 235,1 |
| 37 | -271,610 | | 0,750 | LUFT | 239,3 |
| 38 | 985,139 | | 48,181 | SIO2 | 264,8 |
| 39 | -280,307 | | 0,750 | LUFT | 266,7 |
| 40 | 485,845 | | 42,861 | SIO2 | 265,0 |
| 41 | -19641,172 | | 0,750 | LUFT | 260,0 |
| 42 | ∞ | | 0,750 | LUFT | 259,6 |
| AS | ∞ | | 0,000 | LUFT | 259,6 |
| 43 | 413,812 | | 31,899 | SIO2 | 258,5 |
| 44 | -1463,530 | | 41,090 | LUFT | 257,1 |
| 45 | -229,000 | | 7,000 | SIO2 | 252,9 |
| 46 | -761,338 | | 16,518 | LUFT | 258,2 |
| 47 | -346,924 | | 22,741 | SIO2 | 258,3 |

(fortgesetzt)

| Fläche | Radius | Asphäre | Dicke | Material | Durchm. |
|---|---|---|---|---|---|
| 48 | -221,418 | | 0,750 | LUFT | 260,0 |
| 49 | 265,978 | | 21,446 | SIO2 | 240,4 |
| 50 | 700,398 | | 0,750 | LUFT | 238,8 |
| 51 | 203,760 | | 28,367 | SIO2 | 224,4 |
| 52 | 565,063 | | 0,750 | LUFT | 219,8 |
| 53 | 124,657 | | 33,574 | SIO2 | 185,9 |
| 54 | 255,790 | | 3,089 | LUFT | 175,4 |
| 55 | 192,512 | | 17,352 | SIO2 | 164,2 |
| 56 | 490,117 | A | 9,135 | LUFT | 155, 9 |
| 57 | ∞ | | 57,580 | SIO2 | 148,9 |
| 58 | ∞ | | 2,600 | LUFT | 76, 6 |
| 59 | ∞ | | 8,069 | SIO2 | 69,6 |
| 60 | ∞ | | 12,000 | LUFT | 59,5 |
| IM | | | | | |

Asphärenformel:

$$z = \frac{\frac{1}{R}h^2}{1+\sqrt{1-(1-EX)\left(\frac{1}{R}\right)^2 h^2}} + \sum_{k=1} c_k h^{2k+2}$$

z: Pfeilhöhe; h: Höhe; R: Radius; EX: Exzentrizität; $C_k$: Asphärenkonstanten

ASPHÄRE AN FLÄCHE 9

```
RADIUS    = 1167.44078
EX        = -148.8088700000
C 1       = -.3810274500E-07
C 2       = .1825110100E-11
C 3       = .8703118800E-16
C 4       = -.2547944400E-19
C 5       = .2618280200E-23
C 6       = -.7405173000E-28
```

ASPHÄRE AN FLÄCHE 17

```
RADIUS    = 2327.16189
```

(fortgesetzt)

| | |
|---|---|
| EX | = -543.6641800000 |
| C 1 | = .1496899300E-07 |
| C 2 | = -.4053465300E-11 |
| C 3 | = -.3692162500E-16 |
| C 4 | = .1322169800E-19 |
| C 5 | = -.7575130800E-24 |
| C 6 | = -.1121083700E-27 |

ASPHÄRE AN FLÄCHE 20

| | |
|---|---|
| RADIUS | = -1179.79732 |
| EX | = 88.7124390000 |
| C 1 | = .5780601700E-08 |
| C 2 | = .2633543200E-12 |
| C 3 | = -.3666325900E-16 |
| C 4 | = .7930956500E-21 |
| C 5 | = -.7002646400E-26 |
| C 6 | = -.4010891200E-29 |

ASPHÄRE AN FLÄCHE 25

| | |
|---|---|
| RADIUS | = -1909.59064 |
| EX | = .0000000000 |
| C 1 | = .5895489200E-08 |
| C 2 | = .4254414900E-13 |
| C 3 | = -.4954342300E-18 |
| C 4 | = -.9017812800E-21 |
| C 5 | = .3307499000E-25 |
| C 6 | = -.5028285900E-30 |

ASPHÄRE AN FLÄCHE 56

| | |
|---|---|
| RADIUS | = 490.11681 |
| EX | = -4.7440051000 |
| C 1 | = .6613898200E-08 |
| C 2 | = -.9371994200E-12 |
| C 3 | = .7675398100E-16 |
| C 4 | = -.9919946900E-20 |
| C 5 | = .9420632400E-24 |
| C 6 | = -.4092113200E-28 |

## Patentansprüche

1. Projektionsobjektiv, insbesondere für die Mikrolithographie, mit einer Objektebene, mit einer Bildebene, mit einer Linsenanordnung und mit wenigstens einem mit Gas gefüllten oder mit Gas durchströmten Gasraum als Manipulationsraum (13), der mit einem Druckanschluss (14) versehen ist, über den er mit einer Gasquelle (15) verbunden ist, wobei durch Druckänderungen und/oder Gaszusammensetzungsänderungen im Manipulationsraum (13) die Brechzahl veränderbar ist, **dadurch gekennzeichnet, dass** der Gasraum als wenigstens annähernd planparalleler Manipulationsraum (13) ausgebildet ist, wobei bei Begrenzung des Manipulationsraumes (13) durch wenigstens eine Linse (4a) deren Radius größer 3.000 mm ist.

2. Projektionsobjektiv, nach Anspruch 1, **dadurch gekennzeichnet, dass** sich der Manipulationsraum (13) zwischen der Linsenanordnung (4) und der Bildebene (9) befindet.

3. Projektionsobjektiv, nach Anspruch 1, **dadurch gekennzeichnet, dass** sich der Manipulationsraum (13) in der Linsenanordnung (4) befindet.

4. Projektionsobjektiv nach Anspruch 3, **dadurch gekennzeichnet, dass** der Manipulationsraum (13) zwischen einer Abschlussplatte (12) und der zu der Abschlussplatte (12) benachbart liegenden Linse (4a) angeordnet ist.

5. Projektionsobjektiv nach Anspruch 3, **dadurch gekennzeichnet, dass** eine Abschlussplatte (12) der Linsenanordnung (4) zweigeteilt ist, und dass die beiden Abschlussplattenteile (12a, 12b) auf Abstand voneinander angeordnet sind und zwischen sich den Manipulationsraum (13) bilden.

6. Projektionsobjektiv nach einem der Ansprüche 1 bis 5, **dadurch gekennzeichnet, dass** eine über die Gaszusammensetzung vorgewählte Brechzahl derart einstellbar ist, dass die Brechzahl in beide Richtungen manipulierbar ist.

7. Projektionsobjektiv nach einem der Ansprüche 1 bis 6 mit einer Linsenanordnung, bestehend aus
einer ersten Linsengruppe (LG1) positiver Brechkraft,
einer zweiten Linsengruppe (LG2) negativer Brechkraft,
einer dritten Linsengruppe (LG3) positiver Brechkraft,
einer vierten Linsengruppe (LG4) negativer Brechkraft,
einer fünften Linsengruppe (LG5) positiver Brechkraft und
einer sechsten optischen Gruppe (LG6),
**dadurch gekennzeichnet, dass** in der sechsten optischen Gruppe ein erstes optisches Element (12) mit Krümmungsradien R1 und R2, einer Dicke d1 und einem Durchmesser DU1 vorgesehen ist wobei gilt |R1|>3000mm, R2|>3000mm und

$$\frac{d1}{DU1} > \frac{1}{5}$$

8. Projektionsobjektiv nach einem der Ansprüche 1 bis 7, **dadurch gekennzeichnet, dass** neben dem Manipulationsraum (13) ein weiterer wenigstens annähernd planparalleler manipulierbarer Gaszwischenraum (16) zur Beseitigung von Bildfeldwölbung auf einem zu belichtenden Substrat (11) in der sechsten optischen Gruppe (LG6) vorgesehen ist.

9. Projektionsobjektiv, nach Anspruch 7, **dadurch gekennzeichnet, dass** gilt |R1|>5000mm und |R2|>5000mm

10. Projektionsobjektiv, nach Anspruch 7, 8 oder 9, **dadurch gekennzeichnet, dass** gilt

$$\frac{d1}{DU1} > \frac{1}{4} \quad \text{vorzugsweise} \quad \frac{d1}{DU1} > \frac{1}{3}$$

11. Projektionsobjektiv nach einem der Ansprüche 7 bis 10, **dadurch gekennzeichnet, dass** das erste optische Element (12) und ein zweites optisches Element (12a,4a) der sechsten optischen Gruppe einen Gasraum (13) einschließen, wobei für den Krümmungsradius R3 der Fläche des zweiten optischen Elementes (12a,4a), die der ersten Linse (12) zugewandt ist, gilt:

$$|R3|>3000mm$$

**12.** Projektionsobjektiv nach Anspruch 11, **dadurch gekennzeichnet, dass** für den Krümmungsradius R3 gilt: |R3|>5000mm

**13.** Projektionsobjektiv nach Anspruch 11 oder 12, **dadurch gekennzeichnet, dass** für den Krümmungsradius R4 der weiteren Fläche des zweiten optischen Elementes (12a,4a) gilt: |R4|>3000mm, vorzugsweise |R4|>5000mm

**14.** Projektionsobjektiv nach Anspruch 11, **dadurch gekennzeichnet, dass** das zweite optische Element (12a,4a) eine Dicke d2 aufweist, wobei gilt: d1+d2>60,0mm

**15.** Projektionsobjektiv nach einem der Ansprüche 1 bis 15, **dadurch gekennzeichnet, dass** in der ersten Linsengruppe (LG1) eine Linse (4c) mit einer asphärischen Fläche vorgesehen ist.

**16.** Projektionsobjektiv nach Anspruch 15, **dadurch gekennzeichnet, dass** die Linse (4c) mit der asphärischen Fläche in Lichtrichtung vor dem ersten Bauch angeordnet ist.

**17.** Projektionsobjektiv nach Anspruch 15 oder 16, **dadurch gekennzeichnet, dass** die asphärische Fläche auf der ersten gekrümmten Fläche einer Linse (4c) angeordnet ist.

**18.** Projektionsobjektiv nach mindestens einem der vorangehenden Ansprüche, **dadurch gekennzeichnet, dass** das Projektionsobjektiv (3) bildseitig eine numerische Apertur von mindestens 0,75, vorzugsweise 0,85, aufweist.

**19.** Projektionsbelichtungsanlage der Mikrolithographie mit einer Lichtquelle, die Strahlung von kürzerer Wellenlänge als 370 nm abgibt, **dadurch gekennzeichnet, dass** sie ein Projektionsobjektiv (3) nach zumindest einem der vorangegangenen Ansprüche umfasst.

**20.** Verfahren zur Herstellung mikrostrukturierter Bauteile, bei dem ein mit einer lichtempfindlichen Schicht versehenes Substrat mittels einer Maske und einer Projektionsbelichtungsanlage mit einer Linsenanordnung durch UV-Licht belichtet wird, wobei ein Gasraum als Manipulationsraum (13) mit einem mit einer Gasquelle (15) verbundenen Druckanschluss (14) geschaffen wird, in dem durch Druckänderungen und/oder Gaszusammensetzungsänderungen die Brechkraft manipuliert wird, **dadurch gekennzeichnet, dass** der Manipulationsraum (13) wenigstens annähernd planparallel geschaffen wird, wobei bei Begrenzung des Manipulationsraumes (13) durch wenigstens eine Linse (4a) deren Radius größer 3.000 mm gewählt wird.

**21.** Verfahren nach Anspruch 20, **dadurch gekennzeichnet, dass** der Manipulationsraum (13) in dem Projektionsobjektiv eingangsseitig bzw. auf der Seite der Maske (7) eingerichtet wird.

**22.** Verfahren nach Anspruch 20, **dadurch gekennzeichnet, dass** der Manipulationsraum 13 ausgangsseitig auf der Seite des Wafers (11) eingerichtet wird.

**23.** Verfahren nach Anspruch 20, **dadurch gekennzeichnet, dass** der Manipulationsraum (13) zwischen der Linsenanordnung (4) und der Bildebene (9) eingerichtet wird.

**24.** Verfahren nach Anspruch 20, **dadurch gekennzeichnet, dass** der planparallele Manipulationsraum (13) gegenüber der Umgebung abgedichtet wird, und dass ein Gasgemisch gesteuert über einen Druckanschluss (14) zu dem Manipulationsraum (13) geführt wird.

**25.** Verfahren nach Anspruch 20 und 24, **dadurch gekennzeichnet, dass** bei der Abstimmung des Projektionsobjektives (3) ein Füllgas eingebracht wird, das anschließend beim Betreiber durch ein Gasgemisch ausgetauscht wird.

**26.** Verfahren nach einem der Ansprüche 20 bis 24, **dadurch gekennzeichnet, dass** neben dem Manipulationsraum (13) ein weiterer manipulierbarer Gaszwischenraum (16) vorgesehen wird, durch welchen eine Bildfeldwölbung auf dem zu belichtenden Substrat (11) beseitigt werden kann.

**27.** Verfahren zur Herstellung mikrostrukturierter Bauteile, bei dem ein mit einer lichtempfindlichen Schicht versehenes Substrat (11) mittels einer Maske (7) und einer Projektionsbelichtungsanlage (1) nach einem der Ansprüche 1 bis 19 durch ultraviolettes Licht belichtet wird und gegebenenfalls nach Entwickeln der lichtempfindlichen Schicht entsprechend einem auf der Maske (11) enthaltenen Muster strukturiert wird.

**Claims**

1. Projection objective, in particular for microlithography, having an object plane, having an image plane, having a lens arrangement and having at least one gas space as a manipulation space (13) which is filled with gas or through which gas flows, and which is provided with a pressure connection (14) via which it is connected to a gas source (15), the refractive index in the manipulation space (13) being variable by pressure changes and/or gas composition changes, **characterised in that** the gas space is designed as an at least approximately plane-parallel manipulation space (13), with delimitation of the manipulation space (13) by at least one lens (4a) whose radius is more than 3000 mm.

2. Projection objective according to Claim 1, **characterised in that** the manipulation space (13) is located between the lens arrangement (4) and the image plane (9).

3. Projection objective according to Claim 1, **characterised in that** the manipulation space (13) is located in the lens arrangement (4).

4. Projection objective according to Claim 3, **characterised in that** the manipulation space (13) is arranged between a closure plate (12) and the lens (4a) lying next to the closure plate (12).

5. Projection objective according to Claim 3, **characterised in that** a closure plate (12) of the lens arrangement (4) is divided into two parts, and **in that** the two closure plate parts (12a, 12b) are arranged at a distance from one another and form the manipulation space (13) between them.

6. Projection objective according to one of Claims 1 to 5, **characterised in that** a refractive index preselected via the gas composition is adjustable so that the refractive index is manipulatable in both directions.

7. Projection objective according to one of Claims 1 to 6, having a lens arrangement consisting of
   a first lens group (LG1) with positive refractive power,
   a second lens group (LG2) with negative refractive power,
   a third lens group (LG3) with positive refractive power,
   a fourth lens group (LG4) with negative refractive power,
   a fifth lens group (LG5) with positive refractive power and
   a sixth optical group (LG6),
   **characterised in that** a first optical element (12) with radii of curvature R1 and R2, a thickness d1 and a diameter DU1 is provided in the sixth optical group, with |R1| > 3000 mm, |R2| > 3000 mm $\dfrac{d1}{DU1} > \dfrac{1}{5}$.

8. Projection objective according to one of Claims 1 to 7, **characterised in that** in addition to the manipulation space (13), another at least approximately plane-parallel manipulatable gas interspace (16) is provided in the sixth optical group (LG6) in order to eliminate image field curvature on a substrate (11) to be exposed.

9. Projection objective according to Claim 7, **characterised in that** |R1| > 5000 mm and |R2| > 5000 mm.

10. Projection objective according to Claim 7, 8 or 9, **characterised in that**

$$\frac{d1}{DU1} > \frac{1}{4}, \text{ preferably } \frac{d1}{DU1} > \frac{1}{3}.$$

11. Projection objective according to one of Claims 7 to 10, **characterised in that** the first optical element (12) and a second optical element (12a, 4a) of the sixth optical group enclose a gas space (13), with |R3| > 3000 mm for the radius of curvature R3 of that surface of the second optical element (12a, 4a) which faces the first lens (12).

12. Projection objective according to Claim 11, **characterised in that** |R3| > 5000 mm for the radius of curvature R3.

13. Projection objective according to Claim 11 or 12, **characterised in that** |R4| > 3000 mm, preferably |R4| > 5000 mm for the radius of curvature R4 of the other surface of the second optical element (12a, 4a).

14. Projection objective according to Claim 11, **characterised in that** the second optical element (12a, 4a) has a thickness d2, with d1 + d2 > 60.0 mm.

15. Projection objective according to one of Claims 1 to 15, **characterised in that** a lens (4c) with an aspherical surface is provided in the first lens group (LG1).

16. Projection objective according to Claim 15, **characterised in that** the lens (4c) having the aspherical surface is arranged before the first belly in the light direction.

17. Projection objective according to Claim 15 or 16, **characterised in that** the aspherical surface is arranged on the first curved surface of a lens (4c).

18. Projection objective according to at least one of the preceding claims, **characterised in that** the projection objective (3) has a numerical aperture on the image side of at least 0.75, preferably 0.85.

19. Projection exposure apparatus for microlithography, having a light source which emits radiation with a wavelength shorter than 370 nm, **characterised in that** it comprises a projection objective (3) according to at least one of the preceding claims.

20. Method for producing microstructured components, in which a substrate provided with a photosensitive layer is exposed to UV light by means of a mask and a projection exposure apparatus having a lens arrangement, a gas space having a pressure connection (14) connected to a gas source (15) being provided as a manipulation space (13) in which the refractive power is manipulated by pressure changes and/or gas composition changes, **characterised in that** the manipulation space (13) is configured at least approximately plane-parallel, with delimitation of the manipulation space (13) by at least one lens (4a) whose radius is selected to be more than 3000 mm.

21. Method according to Claim 20, **characterised in that** the manipulation space (13) is installed on the input side in the projection objective, i.e. on the same side as the mask (7).

22. Method according to Claim 20, **characterised in that** the manipulation space (13) is installed on the output side, on the same side as the wafer (13).

23. Method according to Claim 20, **characterised in that** the manipulation space (13) is installed between the lens arrangement (4) and the image plane (9).

24. Method according to Claim 20, **characterised in that** the plane-parallel manipulation space (13) is sealed from the environment, and **in that** a gas mixture is fed in a controlled fashion to the manipulation space (13) via a pressure connection (14).

25. Method according to Claims 20 and 24, **characterised in that** for tuning the projection objective (3), a filler gas is introduced which is substantially replaced by a gas mixture during operation.

26. Method according to one of Claims 20 to 24, **characterised in that** in addition to the manipulation space (13) another manipulatable gas interspace (16) is provided by which an image field curvature of the substrate (11) to be exposed can be eliminated.

27. Method for producing microstructured components, in which a substrate (11) provided with a photosensitive layer is exposed to ultraviolet light by means of a mask (7) and a projection exposure apparatus (1) according to one of Claims 1 to 19, and optionally is structured according to a pattern contained on the mask (11) after having developed the photosensitive layer.

**Revendications**

1. Objectif de projection, notamment pour la microlithographie, avec un plan objet, avec un plan d'image, avec un arrangement de lentilles et avec au moins une chambre remplie d'un gaz ou traversée par un gaz en tant que chambre de manipulation (13) pourvue d'un raccord à pression (14) par l'intermédiaire duquel elle est reliée à une source de gaz (15), l'indice de réfraction pouvant être modifié par des modifications de la pression et/ou de la composition du gaz dans la chambre de manipulation (13), **caractérisé en ce que** la chambre est conçue comme une chambre de manipulation (13) au moins approximativement parallèle au plan, son rayon étant supérieur à 3'000 mm lors de la limitation de la chambre de manipulation (13) par au moins une lentille (4a).

2. Objectif de projection selon la revendication 1, **caractérisé en ce que** la chambre de manipulation (13) se trouve entre l'arrangement de lentilles (4) et le plan image (9).

3. Objectif de projection selon la revendication 1, **caractérisé en ce que** la chambre de manipulation (13) se trouve dans l'arrangement de lentilles (4).

4. Objectif de projection selon la revendication 3, **caractérisé en ce que** la chambre de manipulation (13) se trouve entre une plaque de fermeture (12) et la lentille (4a) disposée à proximité de la plaque de fermeture (12).

5. Objectif de projection selon la revendication 3, **caractérisé en ce qu'**une plaque de fermeture (12) de l'arrangement de lentilles (4) est divisée en deux et **en ce que** les deux parties de la plaque de fermeture (12a, 12b) sont distantes l'une de l'autre et forment entre elles la chambre de manipulation (13).

6. Objectif de projection selon l'une des revendications 1 à 5, **caractérisé en ce qu'**un indice de réfraction présélectionné par la composition du gaz peut être réglé de façon à ce que l'indice de réfraction puisse être manipulé dans les deux directions.

7. Objectif de projection selon l'une des revendications 1 à 6, avec un arrangement de lentilles constitué de :

   un premier groupe de lentilles (LG1) avec un indice de réfraction positif,
   un deuxième groupe de lentilles (LG2) avec un indice de réfraction négatif,
   un troisième groupe de lentilles (LG3) avec un indice de réfraction positif,
   un quatrième groupe de lentilles (LG4) avec un indice de réfraction négatif,
   un cinquième groupe de lentilles (LG5) avec un indice de réfraction positif, et
   un sixième groupe optique (LG6),

   **caractérisé en ce que**, dans le sixième groupe optique se trouve un premier élément optique (12) avec des rayons de courbure R1 et R2, une épaisseur d1 et un diamètre DU1, avec |R1|>3000 mm, |R2|>3000 mm et

$$\frac{d1}{DU1} > \frac{1}{5}.$$

8. Objectif de projection selon l'une des revendications 1 à 7, **caractérisé en ce que**, en plus de la chambre de manipulation (13) une autre chambre intermédiaire manipulable (16) au moins approximativement parallèle au plan est prévue pour l'élimination de la déformation du champ de l'image sur un substrat à éclairer (11) dans le sixième groupe optique (LG6).

9. Objectif de projection selon la revendication 7, **caractérisé en ce que** |R1|>5000 mm et |R2|>5000 mm.

10. Objectif de projection selon la revendication 7, 8 ou 9, **caractérisé en ce que**

$$\frac{d1}{DU1} > \frac{1}{4} \quad \text{et de préférence} \quad \frac{d1}{DU1} > \frac{1}{3}$$

**11.** Objectif de projection selon l'une des revendications 7 à 10, **caractérisé en ce que** le premier élément optique (12) et un deuxième élément optique (12a, 4a) du sixième groupe optique comprennent une chambre de gaz (13), étant valable avec, pour le rayon de courbure R3 de la surface du deuxième élément optique (12a, 4a) qui est orientée vers la première lentille (12) |R3|>3'000 mm.

**12.** Objectif de projection selon la revendication 11, **caractérisé en ce que**, pour le rayon de courbure R3, |R3|>5000 mm.

**13.** Objectif de projection selon la revendication 11 ou 12, **caractérisé en ce que**, pour le rayon de courbure R4 de l'autre surface du deuxième élément optique (12a, 4a),. |R4|>3'000 mm, de préférence |R4|>5' 000 mm.

**14.** Objectif de projection selon la revendication 11, **caractérisé en ce que** le deuxième élément optique (12a, 4a) présente une épaisseur d2, avec d1+d2>60,0 mm.

**15.** Objectif de projection selon l'une des revendications 1 à 14, **caractérisé en ce que**, dans le premier groupe de lentilles (LG1), se trouve une lentille (4c) avec une surface asphérique.

**16.** Objectif de projection selon la revendication 15, **caractérisé en ce que** la lentille (4c) avec une surface asphérique se trouve dans la direction de la lumière avant la première ligne ventrale.

**17.** Objectif de projection selon la revendication 15 ou 16, **caractérisé en ce que** la lentille asphérique se trouve sur la première surface incurvée d'une lentille (4c).

**18.** Objectif de projection selon au moins l'une des revendications précédentes, **caractérisé en ce que** l'objectif de projection (3) présente, du côté de l'image, une ouverture numérique d'au moins 0,75, de préférence 0,85.

**19.** Installation d'éclairage de projection de microlithographie avec une source de lumière qui émet un rayonnement de longueur d'onde inférieure à 370 nm, **caractérisé en ce qu'**elle comprend un objectif de projection (3) selon au l'une des revendications précédentes.

**20.** Procédé de fabrication de composants microstructurés dans lequel un substrat muni d'une couche photosensible est éclairé à l'aide d'un masque et d'une installation d'éclairage de projection avec un arrangement de lentilles, par de la lumière UV, une chambre de gaz étant conçue en tant que chambre de manipulation (13) avec un raccord de pression (14) relié à une source de gaz (15), dans laquelle grâce à des modifications de la pression et/ou de la composition du gaz, l'indice de réfraction peut être ajusté, **caractérisé en ce que** la chambre de manipulation (13) est au moins approximativement parallèle au plan, son rayon étant choisi supérieur à 3'000 mm lors de la limitation de la chambre de manipulation (13) à l'aide d'au moins une lentille (4a).

**21.** Procédé selon la revendication 20, **caractérisé en ce que** la chambre de manipulation (13) se trouve dans l'objectif de projection du côté de l'entrée ou du côté du masque (7).

**22.** Procédé selon la revendication 20, **caractérisé en ce que** la chambre de manipulation (13) se trouve du côté de la sortie du côté de la tranche (11).

**23.** Procédé selon la revendication 20, **caractérisé en ce que** la chambre de manipulation (13) se trouve entre le dispositif à lentilles (4) et le plan image (9).

**24.** Procédé selon la revendication 20, **caractérisé en ce que** la chambre de manipulation (13) parallèle au plan est étanche par rapport à l'environnement et **en ce qu'**un mélange gazeux est guidé de manière contrôlée vers la chambre de manipulation (13) par l'intermédiaire d'un raccord de pression (14).

**25.** Procédé selon les revendications 20 et 24, **caractérisé en ce que**, lors de la mise au point de l'objectif de projection (3) un gaz de remplissage est introduit, qui est ensuite remplacé par un mélange gazeux chez l'utilisateur.

**26.** Procédé selon l'une des revendications 20 à 24, **caractérisé en ce que**, en plus de la chambre de manipulation (13), une autre chambre de gaz intermédiaire (16) est prévue, grâce à laquelle une déformation du champ de l'image peut être supprimée sur le substrat (11) à éclairer.

**27.** Procédé de fabrication de composants microstructurés dans lequel un substrat (11) pourvu d'une couche photosensible est éclairé à l'aide d'un masque (7) et d'une installation d'éclairage de projection (1) selon l'une des revendications 1 à 19, par une lumière UV et, le cas échéant, structuré après le développement de la couche photosensible selon un modèle disposé sur le masque (11).

<u>Fig. 1</u>

Fig. 2

Fig. 3

Fig. 4

Fig. 5

LG1  LG2  LG3  LG4  LG5  LG6

4

4b
4a
12
13

4c

EP 1 164 399 B1

LG1  LG2  LG3  LG4  LG5  LG6

4

4a
12a
12b
13

4c

EP 1 164 399 B1

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4871237 A
- US 4676614 A
- US 5559584 A
- DE 19942281 A
- DE 19855108 A
- DE 19855157 A
- DE 19855158 A